# EUROPEAN PATENT APPLICATION

(11) **EP 3 113 215 A1**
(43) Date of publication of application: **04.01.2017**
(21) Application number: 16175210.0
(22) Date of filing: 20.06.2016
(51) Int. Cl.: H01L 21/66, G01N 21/00, H01L 23/00

(54) **METHOD AND DEVICE FOR INSPECTION OF A SEMICONDUCTOR DEVICE**

(30) Priority: 30.06.2015 EP 15174573
(71) Applicant: IMEC VZW, 3001 Leuven (BE)
(72) Inventor: DE WOLF, Ingrid, 3001 Leuven (BE); JAYAPALA, Murali, 3001 Leuven (BE); PODPOD, Arnita, 3001 Leuven (BE); SLABBEKOORN, John, 3001 Leuven (BE); BLANCH, Carolina, 3001 Leuven (BE)
(74) Representative: Awapatent AB

(57) **Abstract**

A method for inspection of a semiconductor device (10) comprises: performing a processing step in manufacturing of the semiconductor device (10), wherein a compound is at least in contact with the semiconductor device (10); capturing an image on a two-dimensional image sensor (34) of an area of at least part of the semiconductor device (10), wherein the captured image (46) comprises spectral information for a plurality of positions in the area, wherein said spectral information comprises intensity of incident electromagnetic radiation for a plurality of different wavelength bands across a spectrum of wavelengths; processing the spectral information of the captured image (46) for each of the plurality of positions to determine whether residue of the compound is present in the position; and outputting information indicating positions for which residue of the compound is present for controlling a subsequent processing step in manufacturing of the semiconductor device (10).

## Description

### Technical Field

The present invention relates to inspection of a semiconductor device in manufacturing of the semiconductor device.

### Background

In a process of manufacturing semiconductor devices for forming of integrated circuits, a large number of steps are performed in order to create carefully designed patterns that together will provide advanced functionalities. The manufacturing process needs to be tightly controlled since errors in the created patterns could cause the integrated circuit to function poorly or not at all.

Quality of the manufacturing process may be measured in yield of the produced integrated circuits, i.e. a percentage of produced integrated circuits that are of sufficient quality to be sold or output from the manufacturing process. The yield of a semiconductor device manufacturing process should be as high as possible to reduce the manufacturing costs.

A tiny error in a manufacturing step may be accentuated in subsequent steps affecting the yield of the manufacturing process. Thus, it is important that each manufacturing step in the manufacturing process is tightly controlled in order for the manufacturing process to have an acceptable yield. Further, the semiconductor devices are constantly being pushed towards smaller sizes, which set higher requirements on the control of the manufacturing process.

In some processing steps, compounds are temporarily used or compounds that are not desired on the semiconductor device come in contact with the semiconductor device. Cleaning steps may then be performed to remove such compounds from the semiconductor device. This may for instance be the case when the semiconductor device has been in contact with an adhesive, e.g. for attaching the semiconductor device to a carrier. However, even after a cleaning step, unwanted residues of compounds may remain on the semiconductor device and may affect the result of the further manufacturing process.

In view of the importance to control the manufacturing process, inspection tools are used for determining results of manufacturing steps and ensuring that quality may be maintained. In particular, for inspection whether there are residues of compounds remaining on the semiconductor device, inspection tools may typically be quite advanced. Optical inspection may be performed using microscopes or techniques involving irradiating the semiconductor device with a laser may be used. Also, Scanning Electron Microscope (SEM) may be used to inspect a semiconductor device and to detect an image containing information of a topography and composition of a surface of the semiconductor device.

However, such inspection tools require scanning of the semiconductor device and may only depict one specific position of the semiconductor device at a time. This implies that inspection of the semiconductor device is time-consuming. Also, such inspection tools are expensive and it may not be economically viable to analyze results of each processing step in the manufacturing of the semiconductor device, especially if it would imply that a plurality of inspection tools is needed.

Thus, instead of using time-consuming and expensive inspection tools, some processing steps in the manufacturing of the semiconductor device may be performed in such a manner as to minimize errors in the processing step. For instance, in removal of materials that are temporarily used, a removal processing step may be run for an extra long time in order to try to ensure that no residue of the material is left on the semiconductor device. Then, no inspection of the semiconductor device may be necessary after such a removal processing step.

### Summary of the Invention

It is an object of the invention to improve inspection of a semiconductor device. It is a further object of the invention to provide such inspection during manufacture of the semiconductor device to enable control of a manufacturing process.

These and other objects of the invention are at least partly met by the invention as defined in the independent claims. Preferred embodiments are set out in the dependent claims.

According to a first aspect of the invention, there is provided a method for inspection of a semiconductor device in manufacturing of the semiconductor device, said method comprising: performing a processing step in manufacturing of the semiconductor device, wherein a compound is at least in contact with the semiconductor device; capturing an image on a two-dimensional image sensor of an area of at least part of the semiconductor device, wherein the captured image comprises spectral information for a plurality of positions in the area, wherein said spectral information comprises intensity of incident electro-magnetic radiation for a plurality of different wavelength bands across a spectrum of wavelengths; processing the spectral information of the captured image for each of the plurality of positions to determine whether residue of the compound is present in the position; and outputting information indicating positions for which residue of the compound is present for controlling a subsequent processing step in manufacturing of the semiconductor device.

According to a second aspect of the invention, there is provided a device for inspection of a semiconductor device in manufacturing of the semiconductor device, said device comprising: a two-dimensional image sensor, which is arranged for capturing an image of an area of at least part of the semiconductor device, wherein the captured image comprises spectral information for a plurality of positions in the area, wherein said spectral information comprises intensity of incident electro-magnetic radiation for a plurality of different wavelength bands across a spectrum of wavelengths; and a processing unit, which is arranged to receive the captured image from said image sensor and which is configured to process the spectral information of the captured image for each of the plurality of positions to determine whether residue of a compound is present in the position; and output information indicating positions for which residue of the compound is present.

When compounds have at least been in contact with the semiconductor device in a processing step, undesired residues of such compounds may be left on the semiconductor device after the processing step. In order to avoid that residues of compounds affect subsequent processing steps, the semiconductor device may be subject to a removal processing step, such as cleaning of the semiconductor device, in order to remove the compound from the semiconductor device.

It is an insight of the invention that the manufacturing of a semiconductor device may be improved by capturing an image of an area of at least part of the semiconductor device, wherein the captured image comprises spectral information for a plurality of positions in the area. The spectral information may be processed for each of the plurality of positions in order to determine whether there is any residue of the compound in the position. Information indicating positions having residue of the compound may then be used for controlling subsequent processing steps. For instance, it may be determined that further cleaning or removal may be needed and a removal processing step may be repeated in order to remove last residues of the compounds. In this way, better results of the manufacturing of the semiconductor device may be obtained.

Thanks to the invention, manufacturing of semiconductor devices may be improved in that residues from compounds that have at least been in contact with the semiconductor device may be detected at a very early stage. Thus, rather than having a low yield of the manufacturing process of semiconductor devices, problems with residues from compounds may be detected when arising and processing steps may be controlled accordingly.

Further, the invention provides a simultaneous imaging of a plurality of positions of an area of the semiconductor device. This implies that a plurality of positions may be analyzed based on the same imaging step. Therefore, thanks to the invention, it may not be necessary to scan the semiconductor device to individually analyze each position of the semiconductor device, or the entire semiconductor device may be analyzed in few scanning steps. Thus, inspection of the semiconductor device is not unacceptably time-consuming.

Further, the inspection of the semiconductor device may be performed using a two-dimensional image sensor, without requiring advanced equipment for illuminating the semiconductor device or advanced imaging optics for forming an image of the semiconductor device. Thus, the inspection of the semiconductor device may be performed by relatively cheap equipment, which implies that inspection for determining presence of residues of compounds is affordable.

In the context of the present application, the term "semiconductor device" should be construed as any end product or intermediate product comprising semiconductor material(s). The semiconductor device may thus for instance be a semiconductor wafer or a finished chip or integrated circuit, or any intermediate product.

According to an embodiment of the method, said processing of spectral information comprises analyzing the spectral information in relation to a classifier model, which forms a representation of a spectral signature of the compound.

According to an embodiment of the device, the processing unit has access to a classifier model, which forms a representation of a spectral signature of the compound, and the processing unit is further configured to analyze the spectral information in relation to the classifier model.

A classifier model may be created using samples having known positions where a compound is present and known positions where no compound is present. Based on images of such known samples, training may be performed to enable a classifier model to be created, wherein the classifier model distinguishes between presence and absence of a compound. The classifier model may thus enable presence or absence of a compound to be determined based on the spectral information that is captured for positions on the semiconductor device.

The invention according to this embodiment uses a further insight that combining a two-dimensional image sensor that captures spectral information of a plurality of positions with processing of the spectral information in relation to a classifier model facilitates determination of presence or absence of compounds. Thus, thanks to the classifier model created by training, the spectral information need not be divided into a huge number of wavelength bands. Rather, a relatively small number of wavelength bands may be used while allowing determination of presence or absence of compounds with good certainty. Further, since the spectral resolution may be relatively coarse, the image sensor may provide a high spatial resolution such that very small details of the semiconductor device may be analyzed or a large area of the semiconductor device may be analyzed in a single captured image.

Also, the image sensor and an associated imaging system, such as lens packages, may be compact, thanks to using a relatively coarse spectral resolution. This implies that the image sensor and the associated imaging system may be arranged in a manufacturing line of the semiconductor device. This implies that analysis of residues of compounds may be easily integrated in the manufacturing of the semiconductor device.

According to an embodiment of the method, said capturing of an image comprises capturing an image of the entire semiconductor device.

According to an embodiment of the device, the device further comprises an imaging system for forming an image of the entire semiconductor device onto the image sensor.

This implies that no scanning may be necessary in order to analyze the entire semiconductor device. Rather, a single image may be captured and positions throughout the entire area of the semiconductor device may be analyzed within the same image. Hence, imaging of the semiconductor device may be quickly performed and there is no need for equipment enabling scanning of the semiconductor device in relation to the image sensor. For instance, a complete wafer may be imaged in a single captured image.

In an alternative embodiment, a few scanning positions may be used, such that a large part of the semiconductor device is imaged in each scanning position but a few images are needed in order to enable imaging of the entire semiconductor device. Such scanning may for instance be used if a larger spatial resolution is desired.

According to an embodiment of the method, the method further comprises correcting the spectral information based on wavelengthdependent sensitivity of the image sensor and/or wavelength-dependent intensity of a source for irradiating the semiconductor device.

According to an embodiment of the device, the processing unit is further configured to correct the spectral information based on wavelength-dependent sensitivity of the image sensor and/or wavelength-dependent intensity of a source for irradiating the semiconductor device.

The two-dimensional image sensor may have different sensitivity to different wavelengths of electro-magnetic radiation. Such wavelength-dependent sensitivity may also be specific to specific specimens of the image sensor. Hence, in order to ensure that a result of the inspection is not affected by the sensitivity of the individual image sensor, correction may be performed.

Further, the image sensor may be arranged to detect reflectance of electro-magnetic radiation from the semiconductor device. Thus, the semiconductor device is irradiated by a source and the reflected radiation is captured and analyzed to find residues of compounds. However, by means of correcting for a variation in intensity of wavelengths of the irradiated electro-magnetic radiation, it is ensured that such variation does not affect the result of the inspection.

According to an embodiment, the compound is a polymeric compound. In a particular embodiment, the compound is an adhesive.

In some processing steps of the semiconductor device, the semiconductor device may be mounted to a carrier or other support structure by means of an adhesive. When the semiconductor device is removed from the support structure, some residue of the adhesive may be left on the semiconductor device. The semiconductor device may therefore pass a cleaning step, wherein the adhesive residues are to be removed. However, even if an overly thorough cleaning step is applied, there is still a risk that some adhesive residues remain. Thus, according to the invention, such adhesive residues may be detected enabling the manufacturing of the semiconductor device to be controlled accordingly. Further, since the invention indicates at which positions adhesive residue is present, an analysis may be made whether the residue will affect subsequent manufacture of the semiconductor device and a decision may be taken whether the semiconductor device may be passed to subsequent processing steps despite the presence of adhesive residue.

In a particular embodiment, the processing step comprises carrying the semiconductor device to a dicing tape for de-bonding of the semiconductor device from a carrier; and said capturing of an image is performed after cleaning of the semiconductor device to remove adhesive left on the semiconductor device after de-bonding from the carrier.

In manufacturing of three-dimensional integrated circuits, dies may be stacked on top of each other in several steps. Thus, the manufacturing may include several steps of dicing, and there may therefore be several occasions at which adhesive residues after de-bonding of the semiconductor device from a carrier may be left on the semiconductor device. Hence, a risk is also increased that adhesive residues may affect the final product. Therefore, it may be particularly advantageous to analyze the presence of adhesive residue in manufacturing of three-dimensional integrated circuits.

In an embodiment, the method further comprises, based on output information indicating positions for which adhesive residue is present, controlling manufacturing of the semiconductor device to cause further cleaning of the semiconductor device. Thus, if adhesive residue is detected on the semiconductor device, the manufacturing may be controlled in order to perform further cleaning such that the residues may be removed.

According to another embodiment, the processing step comprises picking up a die from a dicing tape. When picking up a die, there is a risk that adhesive residue from the dicing tape may remain on the picked-up die. Thus, according to the embodiment, the die may be analyzed to determine whether any such residue is present on the die. This may be particularly useful in manufacturing of three-dimensional integrated circuits, where dies may be stacked on top of each other. Hence, by imaging the die to be stacked, any adhesive residue that may affect stacking or packaging of the die may be detected before further use of the die.

According to a third aspect of the invention, there is provided a tool for picking up dies from a dicing tape in manufacturing of semiconductor devices, said tool comprising: a two-dimensional image sensor for imaging of the die during pick-up, which is arranged for capturing an image of an area of at least part of the die, wherein the captured image comprises spectral information for a plurality of positions in the area, wherein said spectral information comprises intensity of incident electro-magnetic radiation for a plurality of different wavelength bands across a spectrum of wavelengths.

Hence, according to the third aspect of the invention, an image sensor may be integrated in a tool for picking up dies. Thus, any adhesive residues that may be left on the semiconductor device, e.g. from the dicing tape, may be detected using an image that is captured within the tool. This implies that the tool may be provided with a possibility to perform inspection of a die while it is to be moved, e.g. for stacking the die on top of another die in manufacturing of three-dimensional integrated circuits.

According to another embodiment of the method, the processing step comprises wafer level underfill. In stacking of dies for forming three-dimensional integrated circuits, wafer level underfill may be used for providing adhesive to connect dies to each other. Adhesive residues from the wafer level underfill, in particular on bumps of the dies, may affect the stacking of the dies. According to this embodiment, any adhesive residue in particular positions of the semiconductor device may be detected and may be used for controlling processing steps in stacking of dies.

According to another embodiment, said outputting comprises presenting an image illustrating positions of the semiconductor device for which residue of the compound is present. This implies that the output may be visualized, which may allow an operator that controls manufacture of the semiconductor device to take appropriate measures.

### Brief Description of Drawings

The above, as well as additional objects, features and advantages of the present inventive concept, will be better understood through the following illustrative and non-limiting detailed description of preferred embodiments of the present invention, with reference to the appended drawings. In the drawings like reference numerals will be used for like elements unless stated otherwise.
Fig. 1 is a schematic view illustrating processing steps in manufacturing of a semiconductor device.
Fig. 2 is a schematic view illustrating another processing step in manufacturing of a semiconductor device.
Fig. 3 is a schematic view illustrating a training phase in order to create a classifier model.
Fig. 4 is a schematic view illustrating inspection of a semiconductor device using the classifier model.
Fig. 5 is a displayed image indicating positions on the semiconductor device being classified.

### Detailed Description

Detailed embodiments of the present invention will now be described with reference to the drawings.

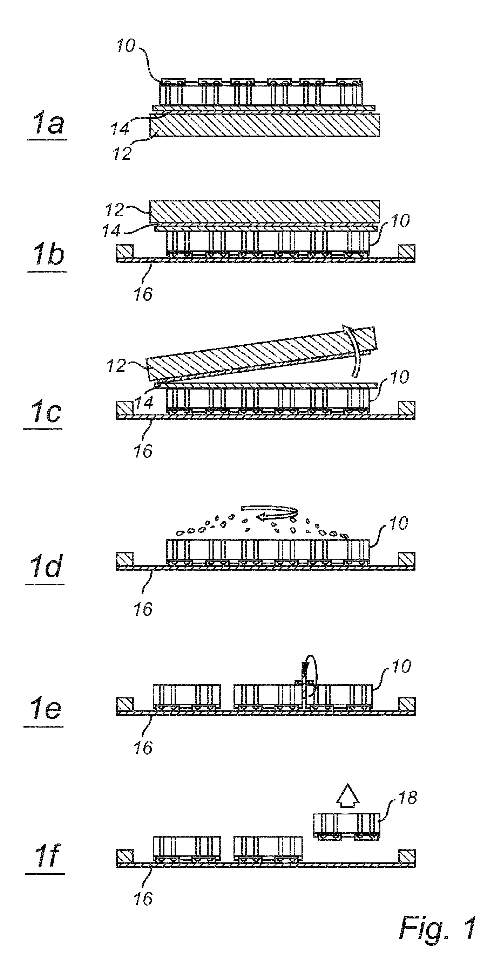

Reference is made to Fig. 1, which illustrates processing steps 1a-f in manufacturing of a semiconductor device 10 comprising a three-dimensional integrated circuit. The processing steps 1a-f may be performed in a preassembly module, where the semiconductor device 10 is handled before dies are stacked on top of each other to form the three-dimensional integrated circuit.

In a first processing step 1 a, the semiconductor device 10 is provided on a process carrier 12, which serves as a support for transporting the semiconductor device 10. An adhesive layer 14 is provided for mounting the semiconductor device 10 to the process carrier 12. The semiconductor device 10 may be in the form of a wafer, on which an appropriate structure has been formed.

In a second processing step 1 b, the process carrier 12 is brought to a dicing tape 16, and the semiconductor device 10 is mounted on the dicing tape 16.

In a third processing step 1 c, de-bonding is performed such that the process carrier 12 is removed and the semiconductor device 10 remains mounted on the dicing tape 16. When performing de-bonding, at least part of the adhesive layer 14 may be left on the semiconductor device 10.

In a fourth processing step 1d, cleaning of the semiconductor device 10 is performed in order to remove the adhesive layer 14. The cleaning step may be performed for a period of time that should be sufficient in order for the adhesive layer 14 to be completely removed.

In a fifth processing step 1 e, the semiconductor device 10 may be cut into separate dies 18 on the dicing tape 16. The dicing tape 16 may be cured by means of exposure to ultraviolet radiation, such that the adhesive bond between the dicing tape 16 and the dies 18 is broken and, preferably, no adhesive residue is left on the die 18 when the die 18 is removed from the dicing tape 16.

In a sixth processing step 1f, the dies 18 are picked up, e.g. by using a pick and place tool. The dies 18 may then e.g. be mounted on top of other dies in order to form a three-dimensional integrated circuit.

As described above, the semiconductor device 10 is in contact with adhesives. If adhesive residues remain on the semiconductor device 10 after the processing steps intended for removing adhesive, such residues may affect the further processing steps for manufacturing a final product. It may therefore be relevant to analyze the semiconductor device 10, at least after processing steps 1d and 1 f to determine whether adhesive residues remain on the semiconductor device 10.

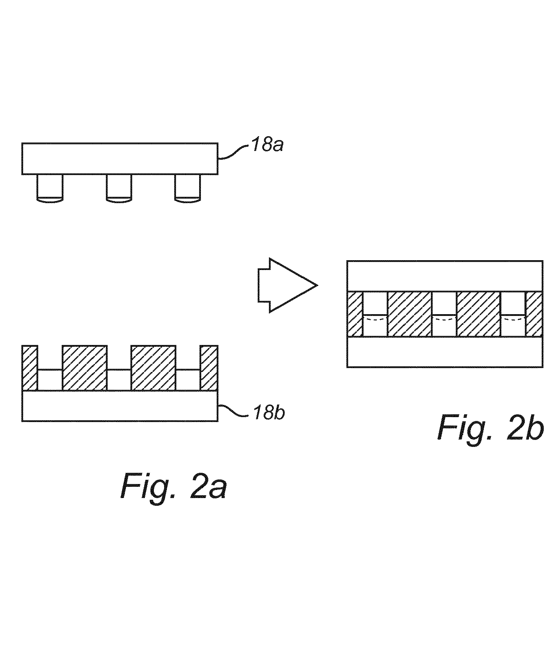

Reference is now made to Fig. 2, which illustrates a processing step 2a in manufacturing of a semiconductor device 10 comprising a three-dimensional integrated circuit. The processing step 2a is performed in a stacking module wherein dies 18a and 18b are to be stacked on top of each other. A wafer level underfill process has been performed to pre-apply underfill material and bumps for forming metallic contacts between the dies 18a and 18b have been opened by removing the underfill material. The dies 18a and 18b may be bonded to each other using e.g. thermocompression bonding. However, if there are adhesive residues on the bumps, the contact between the stacked dies 18a and 18b may be severely affected.

It is a realization according to the invention that in the processing steps illustrated by Figs 1 and 2, it would be advantageous to obtain and provide information whether undesired adhesive residues are present on the semiconductor device 10.

It may also be relevant to determine presence of compounds in connection to other processing steps during manufacture of a semiconductor device 10. For instance, undesired residues of glass material may be present after certain processing steps. Further, polymeric compounds may be present on a semiconductor device post lithography strip, post rework, and post patterning inspection.

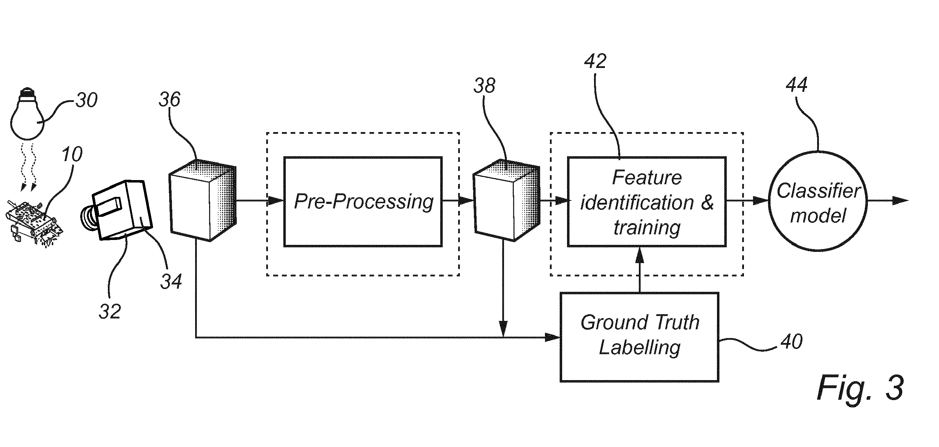

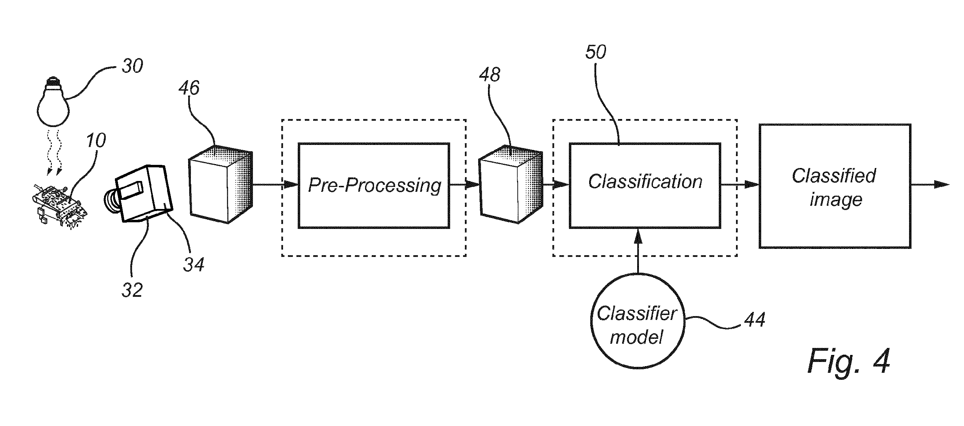

Referring now to Figs 3 and 4, a method for inspection of a semiconductor device 10 will be described. The method may be used for determining presence of residues on the semiconductor device 10.

The method comprises capturing an image of the semiconductor device 10, wherein each imaged position on the semiconductor device 10 provides spectral information. The spectral information may be used for determining the presence of residue of a compound in the position.

As shown in Fig. 3, a training phase may be performed before starting to use the inspection method. In the training phase, samples of semiconductor devices 10 are irradiated by a source 30 of electro-magnetic radiation. The source 30 may be arranged to irradiate an entire wafer 10 or die 18 to be inspected.

A camera 32 may be mounted so as to view the irradiated sample. The camera 32 may comprise an optical system for collecting electro-magnetic radiation and forming an image of the sample onto a two-dimensional image sensor 34. The camera 32 may further comprise a spectral filter, which may be integrated with the two-dimensional image sensor 34. The spectral filter may provide a plurality of narrow ranges of wavelengths for each imaged position, such that spectral information comprising intensity of incident electro-magnetic radiation for a plurality of different wavelength bands across a spectrum of wavelengths may be obtained by the two-dimensional image sensor 34.

The wavelength bands may be a plurality of adjacent wavelength bands in a range of wavelengths. However, according to an alternative, the wavelength bands may be a plurality of selected wavelength bands from a range of wavelengths, wherein the wavelength bands are not necessarily adjacent to each other in the wavelength spectrum. The wavelength bands may be selected in relation to spectral information needed for a classifier model to be able to determine of presence or absence of residues of compounds.

The electro-magnetic radiation from the source 30 may be reflected by the sample and an image of an area of the sample based on the reflected radiation may be captured by the two-dimensional image sensor 34.

The two-dimensional image sensor 34 may thus provide spectral information for a plurality of positions in the imaged area. The captured image 36 thus provides information in three dimensions (two spatial dimensions and a spectral dimension).

The captured image 36 may be transmitted to a processing unit, which may be arranged in the camera 32 or in an external unit. The processing unit may first pre-process the captured image 36 before analysis of the captured image 36 is performed. The pre-processing may include calibration of the captured image 36 (e.g. to adjust levels of recorded intensities to a calibration level), registration of the imaged sample to a coordinate system to enable positions on the sample to be correctly identified, and removal of image artefacts, such as specular reflections. The pre-processing may also include spectral unmixing in order to enable separating spectral information of a pixel into individual contributions from several compounds. The pre-processing may also comprise selection of a region of interest in the captured image 36.

As discussed above, electro-magnetic radiation that is reflected from the semiconductor device 10 may be captured by the two-dimensional image sensor 34. This implies that a reflectance of the semiconductor device 10 may be analyzed in order to determine the presence of residue of a compound on the semiconductor device 10.

In particular, the pre-processing may thus comprise correcting the recorded reflected radiation for wavelength-dependent factors affecting the recorded intensities of radiation. This may imply that any variation of the source 30 and the two-dimensional image sensor 34 may be taken into account. In one embodiment, the wavelength-dependent irradiation of the source 30 and wavelength-dependent sensitivity of the two-dimensional image sensor 34 may be determined by detecting the intensity of reflected radiation from a "white" region, i.e. a region that reflects all wavelengths equally. Based on this determination, the corrected reflectance may be calculated as a recorded intensity in a pixel divided by the recorded intensity of recorded radiation from a "white" region.

The pre-processed image 38 may be combined with known information about the sample. The sample may be provided with known positions on which a compound of interest is present and known positions on which the compound is absent. The known information about the sample may be provided by means of another analysis being performed on the sample (e.g. Raman spectroscopy being performed while scanning the entire sample) or by means of controlled preparation of the sample to provide the compound in selected positions.

The known information may form ground truth labeling 40, classifying positions of the sample into the classes "presence of compound" and "absence of compound". The ground truth labeling 40 may be combined with the pre-processed image 38 providing spectral information of positions corresponding to each class and the ground truth labeling 40 and the pre-processed image 38 may thus form input to a training process 42. The training process 42 may identify features that clearly differentiates the specified classes.

The training process 42 may thus create a reflectance library, which provides reflectance information of different classes. The reflectance library may thus provide information of normal variation within a class and features differentiating specified classes.

The training process 42 may be based on principal component analysis (PCA), linear discriminant analysis (LDA), support vector machines (SVM), spectral angle mapper or other techniques based on statistical regression. The training process 42 may thus create a classifier model 44 which defines whether a position belongs to class "presence of compound" or "absence of compound" based on the spectral information in a pre-processed image 38.

A classifier may create a weighted combination of spectral band values. The coefficients/weights may then provide a distinction between different classes.

The ground truth labeling 40 may provide information of a plurality of classes, such as presence of different types of compounds or combinations of compounds. The ground truth labeling 40 may also or alternatively provide information of classes with relation to bumps, flat substrate surface and borders between the bumps and the substrate surface. The training process 42 may thus create a classifier model 44 which is able to differentiate between all defined classes. It should be realized that a plurality of samples may be used in order to provide a large dataset as input to the training process 42 and improve reliability of the classifier model 44.

In one embodiment, the classifier model 44 may define a plurality of classes, which may define that a position corresponds to "a bump without adhesive residue", "a bump with adhesive residue", "substrate without adhesive residue", "substrate with adhesive residue", "border without adhesive residue", and "border with adhesive residue". The classifier model 44 may include all these classes. In alternative embodiments, the classifier model 44 may include only some of these classes, e.g. the classes relating to border positions between substrate and bumps need not be included, or even further classes corresponding to other characteristics on the semiconductor device 10.

Referring now to Fig. 4, the classifier model 44 may be used in order to inspect a semiconductor device 10 having unknown properties and determine presence of compounds on the semiconductor device 10.

The semiconductor device 10 is irradiated using the same, or a similar, source 30 as used in the training phase. The radiation is reflected off the semiconductor device 10, which is imaged by a camera 32, which may be the same or a similar camera 32 as used in the training phase.

The two-dimensional image sensor 34 may detect, for each imaged position, spectral information comprising intensity of incident electro-magnetic radiation for a plurality of different wavelength bands across a spectrum of wavelengths. The captured image 46 thus provides information in three dimensions (two spatial dimensions and a spectral dimension).

The captured image 46 may be pre-processed using same algorithms or pre-processing steps as in the training phase. The pre-processed image 48 may thus comprise a reflectance of the semiconductor device 10 for each recorded wavelength and position on the semiconductor device 10.

The spectral information of the pre-processed image 48 is processed in a classification step 50. The classification step 50 uses the classifier model 44 as input to analyze the spectral information of each position in relation to the classifier model 44 and determine to which class each position belongs. The classification step 50 may thus output information indicating positions of the semiconductor device 10 that belong to a certain class, e.g. positions having presence of a compound of interest.

The method for inspection of a semiconductor device 10 as described above may be used for detecting presence of an adhesive. The method may be particularly useful in determining presence of an adhesive in the situations described above with reference to Figs 1-2.

In detection of presence of an adhesive, a source 30 may be used for irradiating the semiconductor device 10 with electro-magnetic radiation. The irradiation may in one embodiment span a wavelength spectrum of approximately 400-720 nm. The source 30 may be a halogen light source. In a preferred embodiment, the source 30 may be a set of light-emitting diode (LED) sources. The source 30 may provide uniform irradiation across the semiconductor device 10.

However, other wavelength spectrums may be used. For instance, the source 30 may be arranged to provide irradiation in a wavelength spectrum matching sensitivity of the camera 32. For instance, the irradiation may span a wavelength spectrum of 400-1000 nm. In other embodiments, ultraviolet irradiation may be used in a wavelength spectrum of 200-400 nm, or infrared irradiation may be used in a wavelength spectrum of 1000-2500 nm.

The camera 32 and the two-dimensional image sensor 34 may be arranged to detect spectral information of electro-magnetic radiation reflected off the semiconductor device 10. In one embodiment, spectral information in a range of wavelengths of 400-750 nm may be detected for use in analysis of the semiconductor device 10. It may be contemplated that a narrower or broader range of wavelengths, or even a different range of wavelengths may be used.

In one embodiment, spectral information in a range of wavelengths of 470-630 nm may be detected. In one embodiment, spectral information in a range of wavelengths of 520-630 nm may be detected. In particular, for detection of presence of an adhesive, reflectance measurements in a range of wavelengths of 470-630 nm, or possibly 520-630 nm, may be used.

In other embodiments, spectral information in a range of wavelengths of 200-400 nm, 400-1000 nm or 1000-2500 nm may be detected instead. Further, the camera 32 may not be particularly adapted to capture only the wavelengths necessary in order to correctly classify the positions on the semiconductor device 10. In such case, spectral information spanning a broad range of wavelengths may be captured but only a narrower range of wavelengths may be used in the analysis of the semiconductor device 10.

The spectral information of each position may provide intensity of incident electro-magnetic radiation for a plurality of different wavelength bands across the recorded spectrum. In one embodiment, the spectral information includes 100 spectral bands. Other numbers of spectral bands may be contemplated, e.g. in the range of 8-256 spectral bands. Each spectral band may be detected with a narrow bandwidth, e.g. a full width at half maximum (FWHM) of 10-15 nm.

Using a spectral resolution of 100 spectral bands in a range of a detected spectrum of 400-750 nm allows differentiation of positions having presence of an adhesive from positions where no adhesive residue is present based on a classifier model. However, using considerably fewer spectral bands may still allow differentiation between positions having presence or absence of adhesive residue. For instance, as few as 8-10 spectral bands may be used, including at least spectral bands at approximately 400 nm, 650 nm and 750 nm.

In one embodiment, when a range of wavelengths of 470-630 nm is detected, 16 wavelength bands may be used. In one embodiment, when a range of wavelengths of 520-630 nm is detected, 12 or even fewer wavelength bands may be used.

The spectral resolution provided by the two-dimensional image sensor 34 may affect the spatial resolution that may simultaneously be provided. Using a large spectral resolution implies that there is a large pitch between two adjacent positions being imaged on the two-dimensional image sensor 34. However, by providing a magnification of the optical system of the camera 32, a desired spatial resolution of the semiconductor device 10 may be provided such that the details of interest may be resolved. A spatial resolution of about 1 µm may be useful for detecting whether any adhesive residues remain on the semiconductor device 10. In one embodiment, using a spectral resolution of 100 bands, a magnification of 10x may be used for obtaining the desired spatial resolution. However, it should be realized that both larger and smaller magnifications may be used.

As discussed above, a relatively low magnification of the semiconductor device 10 may be used by the optical system of the camera 32. For instance, where 10x magnification is used, this implies that an entire wafer may be imaged in a single captured image 46. Hence, no scanning may be necessary in order to determine presence of compounds on different parts of the wafer. For larger magnifications, such as 100x magnification, some scanning may be necessary depending on size of an area of the semiconductor device 10 to be inspected.

As described above, requirements on the optical system of the camera 32 and the size of the two-dimensional image sensor 34 are so limited that the camera 32 may be very compact. This implies that the camera 34 may be arranged in a processing line for manufacturing of the semiconductor device 10. Thus, inspection of the semiconductor device 10 may be performed in the processing line. There is hence no need to withdraw semiconductor devices 10 from the processing line in order to allow for inspection. Also, the inspection of the semiconductor device 10 may provide immediate feedback to a manufacturing process, and processing steps in manufacturing of the semiconductor device 10 may be controlled based on the inspection.

Inspection of the semiconductor device 10 after the processing step 1 d may for instance be used to control that further cleaning is performed, possibly on selected parts of the semiconductor device 10, to remove any adhesive residue.

Inspection of the semiconductor device 10 after the processing step 1f may for instance be used to control whether the picked-up die 18 need to be cleaned before stacking onto another die. The camera 32 may be incorporated in a pick and place tool for picking up dies 18 and placing the dies 18 in manufacturing of three-dimensional integrated circuits. A die 18 may thus be imaged when it is picked up or is about to be picked up in order to provide immediate feedback regarding the dies 18 handled by the tool.

The two-dimensional image sensor 34 may be arranged to transmit the captured image 46 or the pre-processed image 48 to an external processing unit, which need not be placed in the processing line for manufacturing of the semiconductor device 10. The external processing unit may be provided in a control room and may further be connected to an output device for presenting information to an operator. For instance, information indicating positions on the semiconductor device 10 being classified as belonging to a certain class may be presented on a display.

In a particular embodiment, a method for inspection of a semiconductor device 10 in manufacturing of the semiconductor device 10 is performed to detect residues of an adhesive. The method comprises: performing a processing step in manufacturing of the semiconductor device 10, wherein an adhesive is at least in contact with the semiconductor device 10, and wherein the semiconductor device comprises bumps and an essentially flat substrate between bumps; irradiating the semiconductor device 10 using a source 30; capturing an image on a two-dimensional image sensor 34 of reflected irradiation from an area of at least part of the semiconductor device 10, wherein the captured image 46 comprises spectral information for a plurality of positions in the area, wherein said spectral information comprises intensity of incident electro-magnetic radiation for a plurality of different wavelength bands across a spectrum of wavelengths; processing the spectral information of the captured image 46 for each of the plurality of positions to determine whether residue of the adhesive is present in the position, wherein said processing comprises analyzing the spectral information in relation to a classifier model 44, which forms a representation of a spectral signature of the adhesive taking into account whether the adhesive is arranged on a bump or on the substrate; and outputting information indicating positions for which residue of the adhesive is present for controlling a subsequent processing step in manufacturing of the semiconductor device 10.

In one embodiment, the source 30 may provide irradiation in a range of wavelengths of 400-700 nm. It should be realized that the source 30 may alternatively provide irradiation in an even broader wavelength spectrum, at least including the wavelengths for which reflected radiation is to be recorded.

In one embodiment, spectral information in a range of wavelengths of 470-630 nm may be detected. In one embodiment, spectral information in a range of wavelengths of 520-630 nm may be detected. For detection of presence of an adhesive, reflectance measurements in such ranges of wavelengths may be particularly useful.

In one embodiment, by providing a magnification of the optical system of the camera 32, a desired spatial resolution of the semiconductor device 10 may be provided such that the details of interest may be resolved, enabling classifying bumps and presence or absence of an adhesive. A spatial resolution of about 1 µm may be useful for detecting whether any adhesive residues remain on the semiconductor device 10 and also to enable taking into account effects of a presence of a bump on the semiconductor device 10.

Bumps on the semiconductor device 10 may typically have a diameter of 10-50 µm. Thus, if the spatial resolution is about 1 µm, a bump may be imaged having a 10 pixel diameter, which may provide for reliable determination that a bump is present and also allow the analysis using the classifier model 44 to differentiate the presence of a bump from presence or absence of an adhesive.

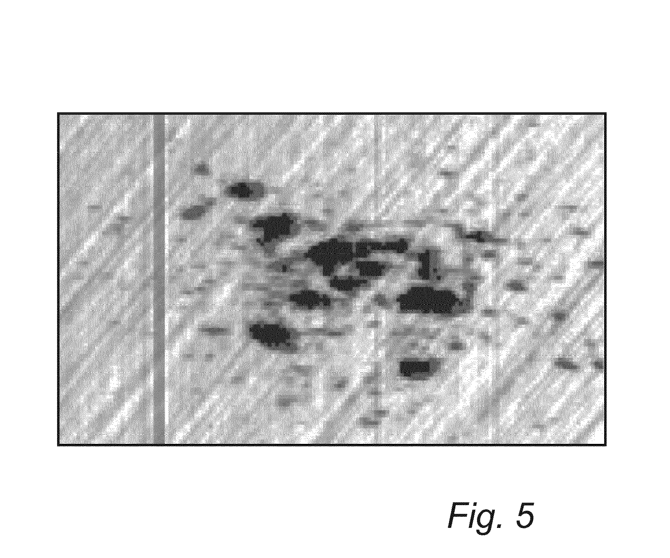

Fig. 5 shows a displayed image indicating positions on the semiconductor device 10 being classified as having presence of adhesive residues. Such an image may be displayed to an operator in order to allow controlling of the manufacturing process.

In the above the invention has mainly been described with reference to a limited number of embodiments. However, as is readily appreciated by a person skilled in the art, other embodiments than the ones disclosed above are equally possible within the scope of the invention, as defined by the appended claims.

## Claims

1. A method for inspection of a semiconductor device (10) in manufacturing of the semiconductor device (10), said method comprising:
performing a processing step in manufacturing of the semiconductor device (10), wherein a compound is at least in contact with the semiconductor device (10);
capturing an image on a two-dimensional image sensor (34) of an area of at least part of the semiconductor device (10), wherein the captured image (46) comprises spectral information for a plurality of positions in the area, wherein said spectral information comprises intensity of incident electro-magnetic radiation for a plurality of different wavelength bands across a spectrum of wavelengths;
processing the spectral information of the captured image (46) for each of the plurality of positions to determine whether residue of the compound is present in the position; and
outputting information indicating positions for which residue of the compound is present for controlling a subsequent processing step in manufacturing of the semiconductor device (10).

2. The method according to claim 1, wherein said processing of spectral information comprises analyzing the spectral information in relation to a classifier model (44), which forms a representation of a spectral signature of the compound.

3. The method according to claim 1 or 2, wherein said capturing of an image comprises detecting spectral information in a range of wavelengths of 470-630 nm.

4. The method according to any one of the preceding claims, wherein the compound is an adhesive.

5. The method according to claim 4, wherein the processing step comprises carrying the semiconductor device (10) to a dicing tape (16) for de-bonding of the semiconductor device (10) from a carrier (12); and said capturing of an image is performed after cleaning of the semiconductor device (10) to remove adhesive left on the semiconductor device (10) after de-bonding from the carrier (12).

6. The method according to claim 5, further comprising, based on output information indicating positions for which adhesive residue is present, controlling manufacturing of the semiconductor device (10) to cause further cleaning of the semiconductor device (10).

7. The method according to claim 4, wherein the processing step comprises picking up a die (18) from a dicing tape (16).

8. The method according to claim 4, wherein the processing step comprises wafer level underfill.

9. The method according to any one of the preceding claims, wherein said outputting comprises presenting an image illustrating positions of the semiconductor device (10) for which residue of the compound is present.

10. The method according to any one of the preceding claims, further comprising correcting the spectral information based on wavelength-dependent sensitivity of the image sensor (34) and/or wavelength-dependent intensity of a source (30) for irradiating the semiconductor device (10).

11. A device for inspection of a semiconductor device (10) in manufacturing of the semiconductor device (10), said device comprising:
a two-dimensional image sensor (34), which is arranged for capturing an image of an area of at least part of the semiconductor device (10), wherein the captured image (46) comprises spectral information for a plurality of positions in the area, wherein said spectral information comprises intensity of incident electro-magnetic radiation for a plurality of different wavelength bands across a spectrum of wavelengths; and
a processing unit, which is arranged to receive the captured image (46) from said image sensor (34) and which is configured to process the spectral information of the captured image (46) for each of the plurality of positions to determine whether residue of a compound is present in the position; and output information indicating positions for which residue of the compound is present.

12. The device according to claim 11, wherein the processing unit has access to a classifier model (44), which forms a representation of a spectral signature of the compound, and wherein the processing unit is further configured to analyze the spectral information in relation to the classifier model (44).

13. The device according to claim 11 or 12, further comprising an imaging system for forming an image of the entire semiconductor device (10) onto the image sensor (34).

14. The device according to any one of claims 11-13, wherein said processing unit is further configured to correct the spectral information based on wavelength-dependent sensitivity of the image sensor (34) and/or wavelength-dependent intensity of a source (30) for irradiating the semiconductor device (10).

15. A tool for picking up dies (18) from a dicing tape (16) in manufacturing of semiconductor devices (10), said tool comprising:
a two-dimensional image sensor (34) for imaging of the die (18) during pick-up, which is arranged for capturing an image of an area of at least part of the die (18), wherein the captured image (46) comprises spectral information for a plurality of positions in the area, wherein said spectral information comprises intensity of incident electro-magnetic radiation for a plurality of different wavelength bands across a spectrum of wavelengths.
